# EUROPEAN PATENT APPLICATION

(11) **EP 4 672 298 A2**
(43) Date of publication of application: **31.12.2025**
(21) Application number: 25179025.9
(22) Date of filing: 27.05.2025
(51) Int. Cl.: H01J 37/21, H01J 37/28

(54) **LENS ARRANGEMENT IN AN ELECTRON MICROSCOPY SYSTEM**

(30) Priority: 05.06.2024 US 202418734325
(71) Applicant: FEI COMPANY, Hillsboro, OR 97124 (US)
(72) Inventor: ZÁVODNÝ, Adam, Brno (CZ); UNCOVSKÝ, Marek, Brno (CZ); VASINA, Radovan, Brno (CZ); SKARVADA, Pavel, Brno (CZ); KUCERA, Adam, Brno (CZ); XU, Xin, Garland (US)
(74) Representative: Boult Wade Tennant LLP

(57) **Abstract**

A charged particle beam system includes a source of charged particles and a charged particle beam column to focus the charged particles into a charged particle beam having a landing energy. A magnetic lens is formed in the charged particle beam column along an axis based on a magnetic lens excitation in the coils. The magnetic lens focuses the charged particle beam at a first crossover on the axis. An electrostatic lens is formed in the charged particle beam column along the axis based on a voltage applied to the booster tube. The electrostatic lens focuses the charged particle beam at a second crossover on the axis. The first crossover is based on the magnetic lens excitation. The introduction of an extra crossover overcomes previous limitations of the maximum working distance at very small landing energies and maximum field of view.

## Description

The present disclosure is directed to charged particle microscope system components, systems, and methods. More particularly, the present disclosure describes lens arrangements in electron microscopy systems.

### BACKGROUND

Charged particle beam systems are used in a variety of applications including the manufacturing, repair, and inspection of miniature devices, such as integrated circuits, magnetic recording heads, and photolithography masks. One type of charged particle beam system may include an electron microscope. Electron microscopes are used as imaging tools by focusing an electron beam at a sufficient size from an electron emitter onto a sample and then detecting the deflected electrons to generate a high-resolution image of the sample. New charged particle beam systems optimizing the detection of those deflected electrons are desired.

### SUMMARY

According to one embodiment, a charged particle beam system includes a source of charged particles and a charged particle beam column to focus the charged particles into a charged particle beam having a landing energy. The charged particle beam column includes a booster tube, a set of scanning deflectors, a set of magnetic materials, and a set of magnetic lens excitation coils that at least partially surround the booster tube and the set of scanning deflectors. A magnetic lens is formed in the charged particle beam column along an axis based on a magnetic lens excitation in the coils. The magnetic lens focuses the charged particle beam at a first crossover on the axis. An electrostatic lens is formed in the charged particle beam column along the axis. Taken together, the magnetic lens and the electrostatic lens comprise a compound final lens of the charged particle beam column. The electrostatic lens is formed based on a gradient of potentials applied to the booster tube and other parts of the final lens. The electrostatic lens focuses the charged particle beam at a second crossover on the axis. The first crossover is between the magnetic lens and the electrostatic lens and is based on the magnetic lens excitation of the magnetic lens.

The charged particle beam system may include various optional embodiments. The landing energy may be greater than or equal to 1 eV and less than or equal to 500 eV. A working distance of the charged particle beam column is greater than or equal to 1 mm. The working distance may be based on the magnetic lens excitation. The booster tube voltage may be constant during imaging of a sample at the working distance. An electric current applied to the magnetic lens excitation coils may be sufficient to generate a magnetomotive force greater than or equal to 200 Ampere-turns and less than or equal to 1000 Ampere-turns. The first crossover may be proximate to an end of the booster tube that is between the magnetic lens and the electrostatic lens.

According to another embodiment, a method for imaging a target includes directing a charged particle beam along an axis of a charged particle beam column having a landing energy. The charged particle beam column includes a booster tube, a set of scanning deflectors, and a set of magnetic materials that at least partially surround the booster tube and the set of scanning deflectors. The method includes applying a voltage to the booster tube such that an electrostatic lens is formed in the charged particle beam along the axis, applying a magnetic lens excitation to the set of scanning deflectors such that a magnetic lens is formed in the charged particle beam along the axis, and controlling the magnetic lens excitation such that the magnetic lens focuses the charged particle beam at a first crossover on the axis. The first crossover is between the magnetic lens and the electrostatic lens. The electrostatic lens focuses the charged particle beam at a second crossover on the axis.

The method may include various optional embodiments. The method may include receiving an image including an image distortion and correcting for the image distortion by image post-processing or by altering dynamic excitation of the set of scanning deflectors where correcting for the image distortion comprises using virtual (e.g., physical or artificial intelligence (AI) or the like) model to apply a transformation to the image. The method may further include imaging a known target using at least a first setting of a scanning electron microscope that includes the charged particle beam column, determining an image transformation based on the imaging of the known target, generating an image of the known target at a working distance based on the charged particle beam, and updating the image based on the image transformation. The method may further include controlling the magnetic lens excitation such that the working distance of the charged particle beam column is equal to or greater than 1 mm. The method may further include generating a plurality of images of the known target, each image corresponding to a different one of a plurality of settings of the scanning electron microscope, wherein the image transformation is based on the plurality of images. Imaging the known target may include generating an image of the known target by at least varying one or more of the first crossover, the second crossover, a position of the known target, or a beam characteristic where the image transformation is based on the image. The landing energy may be greater than or equal to 1 eV and less than or equal to 500 eV. The method may further include controlling the magnetic lens excitation such that the first crossover is proximate to an end of the booster tube.

According to yet another embodiment, one or more non-transitory computer-readable storage media store instructions that, upon execution by a set of processors, cause operations including directing a charged particle beam along an axis of a charged particle beam column having a landing energy. The charged particle beam column includes a booster tube, a set of scanning deflectors, and a set of magnetic materials that at least partially surround the booster tube and the set of scanning deflectors. The operations include applying a voltage to the booster tube such that an electrostatic lens is formed in the charged particle beam along the axis, applying a magnetic lens excitation such that a magnetic lens is formed in the charged particle beam along the axis, and controlling the magnetic lens excitation such that the magnetic lens focuses the charged particle beam at a first crossover on the axis. The first crossover is between the magnetic lens and the electrostatic lens. The electrostatic lens focuses the charged particle beam at a second crossover on the axis.

The operations may include various optional embodiments. The landing energy may be greater than or equal to 1 eV and less than or equal to 500 eV. The operations may further include imaging a known target using at least a first setting of a scanning electron microscope that includes the charged particle beam column, determining an image transformation based on the imaging of the known target, generating an image of the known target at a working distance based on the charged particle beam, and updating the image based on the image transformation. The operations may further include generating a plurality of images the known target, each image corresponding to a different respective one of a plurality of settings of the scanning electron microscope, wherein the image transformation is based on the images. The operations may further include controlling the magnetic lens excitation such that a working distance of the charged particle beam column is equal to or greater than 1 mm. The operations may further include controlling the magnetic lens excitation such that the first crossover is proximate to an end of the booster tube.

### DESCRIPTION OF THE DRAWINGS

A further understanding of the nature and advantages of various embodiments may be realized by reference to the following figures. In the appended figures, similar components or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.
FIG. 1 depicts a simplified cross-sectional view of an example charged particle system.
FIG. 2 depicts a simplified cross-sectional view of an example charged particle system according to an embodiment of the disclosure.
FIG. 3A depicts a simplified cross-sectional view of an example charged particle system having navigation mode according to an embodiment of the disclosure.
FIG. 3B depicts the simplified cross-sectional view of an example charged particle system having navigation mode of FIG. 3A scanning a relatively large field of view according to an embodiment of the disclosure.
FIG. 4 is a flowchart of a method for imaging a target according to an embodiment of the present disclosure.
FIG. 5 illustrates image distortion and correction according to an embodiment of the disclosure.
FIGS. 6A and 6B include flowcharts of a method for correcting image distortion according to an embodiment of the present disclosure.
FIG. 7 is a graph representing image distortion according to an embodiment of the present disclosure.
FIG. 8 is a table representing exemplary working distances according to an embodiment of the present disclosure.
FIG. 9 is a block diagram of a controller for a charged particle microscope system according to an embodiment of the present disclosure.

### DETAILED DESCRIPTION

While exemplary embodiments have been illustrated and described, it will be appreciated that various changes can be made therein without departing from the spirit and scope of the disclosure.

Charged particle microscopy is used in various industries, including the semiconductor industry, to analyze micrometer and nanometer scale structures. For example, semiconductor devices can include nanometer scale transistors densely arranged within a silicon wafer. Images obtained with charged particle microscopy can be used to improve process control, evaluate the quality of fabricated devices, and improve yields. In the case of semiconductor devices, objects like field effect transistors (FETs) may be formed within the larger silicon wafer and adjacent to several other structures, including other FETs, vias, diode junctions, and the like. Because of the extremely small scale and dense packing of the elements, imaging of these elements can be improved by careful preparation of the sample.

Imaging samples with a charged particle microscope can include using a transmission electron microscope (TEM), a scanning electron microscope (SEM), a scanning TEM (STEM), or related techniques. To image some samples using these techniques, a lamella is formed and removed from the larger substrate (e.g., the silicon wafer). The lamella can include the structures forming the devices (e.g., FETs). The lamella can be formed and removed using a dual beam charged particle microscope system, which typically includes a focused ion beam (FIB) and a SEM. During the lamella formation process, the FIB is used to remove material from the substrate, leaving the lamella as a portion of the remaining material, while the SEM is used for imaging to guide the FIB process. This process has become conventional in many industries, not just the semiconductor industry, and is used to image and analyze almost any type of micron or nanometer scale structure buried within a surrounding substrate.

The SEM is a versatile instrument that enables imaging of samples on different length scales. The standard workflow involves finding the region of interest in the sample followed by sequential magnification to the desired detail. The maximum field of view may be achieved by increasing the working distance for simple goniometric reasons. However, if the SEM is equipped with a booster tube (also known as an acceleration tube), the maximum working distance decreases with decreasing landing energy. The booster tube is used for imaging stability at low energies (e.g., between 50 eV and 500 eV, inclusive), but it limits the maximum working distance. For example, the booster tube may have a maximum working distance of 2.8 mm at 80 eV. Furthermore, the booster tube limits the maximum field of view, for example, to 1.2 mm at the working distance of 2.3 mm and 200 eV.

In one exemplary use case, for electrical fault analysis (EFA), one tends to lower the landing to tens of electron volts. Only very low beam energies (e.g., 200 eV or preferably even less) can be used. Otherwise, the sample is degraded. In this case, the field of view necessary for the navigation along the sample is not sufficient. In the case of very small landing energies, the working distance is on the order of millimeters. Various embodiments of the present disclosure describe a navigation mode of a microscope having a booster tube that enable increased working distances with lower landing energies.

Charged particle microscopy, such as TEMs and SEMs, can use an array of detection techniques to obtain information about a sample. SEM and TEM techniques may be used to image various types of samples including surfaces/interiors of cells, structures of protein molecules, organization of molecules in viruses and cytoskeletal filaments, etc. TEMs specifically may use various techniques depending on the type of sample to be imaged. Due to intrinsic laws of nature, electrons within the electron beam scatter after interacting with the sample. As a result, many of the electrons experience energy loss and, consequently, experience imaging plane focal shifts associated with chromatic aberrations which requires adjusting the lensing optics in order to acquire a high-resolution image as well as various degrees of geometric aberrations which may affect image quality by introducing astigmatisms and blurriness. Accordingly, an imaging resolution may be negatively affected by various aberrations, and a solution may be needed to achieve high resolution imaging using various TEM and SEM devices.

Various embodiments of the present disclosure provide a lens arrangement that increases the maximum working distance for low landing energies, in particular, a lens arrangement in an SEM or TEM system having a booster tube. At least some embodiments provide a new usage of the magnetostatic and electrostatic compound final lens of the charged particle beam column. The lens arrangement described herein enables navigation of a relatively large field of view as compared to conventional systems. In at least some embodiments, the lens arrangement provides an additional crossover in the final lens of the arrangement, thereby providing a navigation mode of the system having a substantial increase in the maximum working distance and field of view.

According to at least some embodiments, some distortion may occur during imaging using the navigation mode described herein. The compound magnetic lens and electrostatic lens refract electron beams. The greater distance of rays in the electrostatic lens may cause some image distortion. Various embodiments describe a model of distortion and the implementation of an undistortion procedure using digital post-processing.

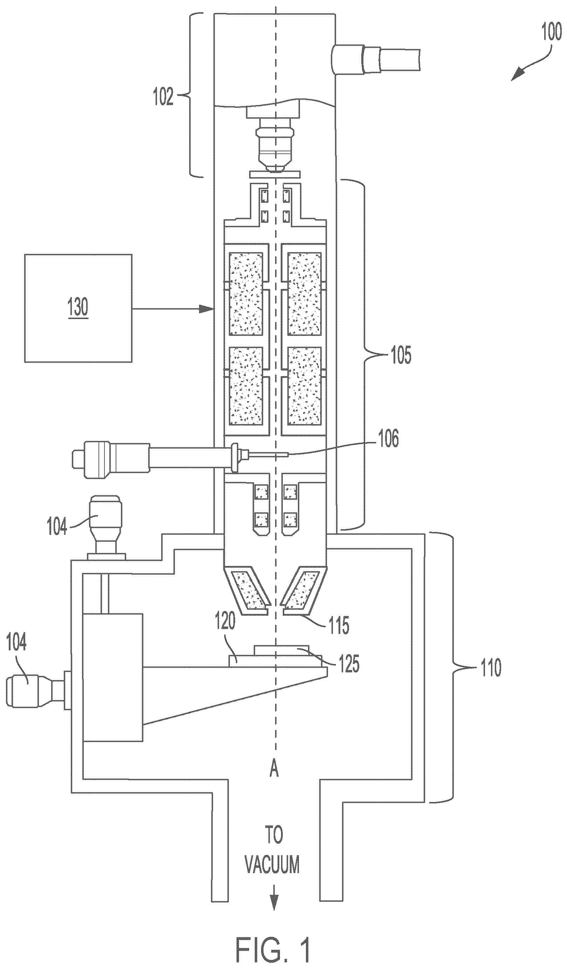

FIG. 1 is a schematic diagram of an example charged particle microscope 100, in accordance with some embodiments of the present disclosure. Example charged particle microscope 100 includes multiple sections including an electron source 102, a beam column 105, and a sample chamber 110. The electron source 102 includes high-voltage supply components (not illustrated), vacuum system components, and an electron emitter (not illustrated) configured to generate a beam of electrons that is accelerated into the beam column 105. The beam column 105, in turn, can include electromagnetic lens elements and/or an aperture plate 106 that are configured to shape and form the beam of electrons from the electron source 102 into a substantially circular beam with a substantially uniform profile transverse to a beam axis A, and conditions the beam to be focused onto a sample 125 by an objective lens 115.

The beam of electrons is typically characterized by a beam current, and an accelerating voltage applied to generate the beam, among other criteria. The ranges of beam current and accelerating voltage can vary between instruments and are typically selected based on material properties of the sample or the type of analysis being conducted. Generally, however, beams of electrons are characterized by an energy from units of electronvolts up to tens of kiloelectronvolts and a beam current from picoamperes to microamperes.

The sample chamber 110 and/or the beam column 105 can include multiple detectors for various signals, including but not limited to secondary electrons generated by interaction of the beam of electrons and the sample, X-ray photons (e.g., detectors for energy-dispersive X-ray analysis or EDAX), other photons (e.g., visible and/or IR cameras), and/or molecular species (e.g., time-of-flight secondary ion mass spectrometry, or TOF-SIMS, systems). The sample chamber 110 can also include a sample holder 120 that can be operably coupled with a multi-axis translation/rotation control system 104 such that the sample 125 can be repositioned relative to the beam axis A, as an approach to surveying and/or imaging the sample 125. Further, the sample holder 120 can include windows permitting transmission of electrons or other charged particles through the sample and the sample stage.

Various embodiments of the present disclosure redefine the lenses of the SEM system. SEM systems may include two lenses in a sequential configuration including a magnetic lens and an electrostatic lens, to be described in further detail below. The embodiments described herein provide two crossovers in front of the electrostatic lens such that the electrostatic lens has a constant refraction power. The actual correction in focus is produced by the magnetic lens and the shift of a first crossover is translated by the electrostatic lens into focusing on the sample. Accordingly, embodiments of the present disclosure enable a substantial increase of maximum working distance and field of view in ranges previously inaccessible by conventional SEM systems.

Although the remaining portions of the description will routinely reference SEMs, it will be readily understood by the skilled artisan that the technology is not so limited. The present designs may be employed with other types of charged particle microscope, such as transmission TEM, STEM, dual beam systems including an ion beam source and an electron beam source, reflection electron microscopes (REM), circuit editing microscopes, or the like. Accordingly, the disclosure and claims are not to be considered limited to any particular example microscope discussed but can be utilized broadly with any number of electron microscopes that may exhibit some or all of the electrical or chemical characteristics of the discussed examples.

Although the remaining portions of the description will routinely reference SEMs, it will be readily understood by the skilled artisan that the technology is not so limited. The present designs may be employed with other types of charged particle microscope, such as transmission TEM, STEM, dual beam systems including an ion beam source and an electron beam source, reflection electron microscopes (REM), circuit editing microscopes, or the like. Accordingly, the disclosure and claims are not to be considered limited to any particular example microscope discussed but can be utilized broadly with any number of electron microscopes that may exhibit some or all of the electrical or chemical characteristics of the discussed examples.

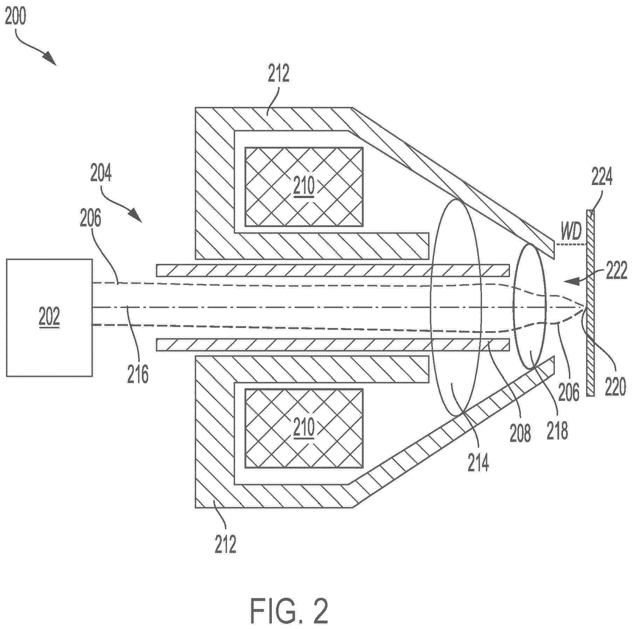

FIG. 2 depicts a simplified cross-sectional view of an exemplary charged particle system. In particular, the charged particle system 200 as shown in FIG. 2 may be implemented in the system of FIG. 1 described in detail above. However, the charged particle system 200 as shown in FIG. 2 may be similarly implemented in an SEM system having a plurality of optics or the like. The charged particle system 200 includes a source of charged particles 202 (e.g., electrons), as described in detail above. A charged particle beam column 204 may be configured to focus the charged particles into a charged particle beam 206 having a landing energy. The charged particle beam column 204 may include a booster tube 208 and a set of magnetic materials 212. The set of magnetic materials 212 may at least partially surround the booster tube 208, as shown in FIG. 2.

According to various embodiments, the tube of the booster tube 208 can be made of a variety of materials, such as titanium alloy and some suitable insulating materials, that allows the components inside the booster tube 208 to be electrically insulated from ground potential. The booster tube 208 does not necessarily have to be composed of a physical tube. It can also refer to a system comprising the middle section of the charged particle beam column 204 wherein the middle section can be set to a higher voltage level.

According to various embodiments, a magnetic lens 214 is formed in the charged particle beam column 204 along an axis 216. The magnetic lens 214 may be based on a magnetic lens excitation current applied the set of coils 210. Furthermore, the charged particle system 200 may include an electrostatic lens 218 formed along the axis 216 in the charged particle beam column 204. The electrostatic lens 218 may be formed based at least in part on a voltage applied to the booster tube 208. For example, the electrostatic lens 218 may be formed by the voltage difference between a voltage applied to the booster tube 208 (e.g., 8 kV) and a voltage applied to the magnetic materials 212 (e.g., 0 V). The magnetic lens 214 and the electrostatic lens 218 may form a beam crossover 220 at or on a sample for imaging a sample or the like. A working distance (WD) refers to the distance between an outlet 222 of the charged particle beam column 204 and the top of a sample 224 or the like.

Within various conventional SEM systems, the maximum working distance is too short at low landing energies and consequently, the field of view cannot be extended into dimensions that would enable navigation across a sample. For example, such systems may only provide one maximum magnification at a certain working distance and/or do not include the possibility of zooming out to different working distances.

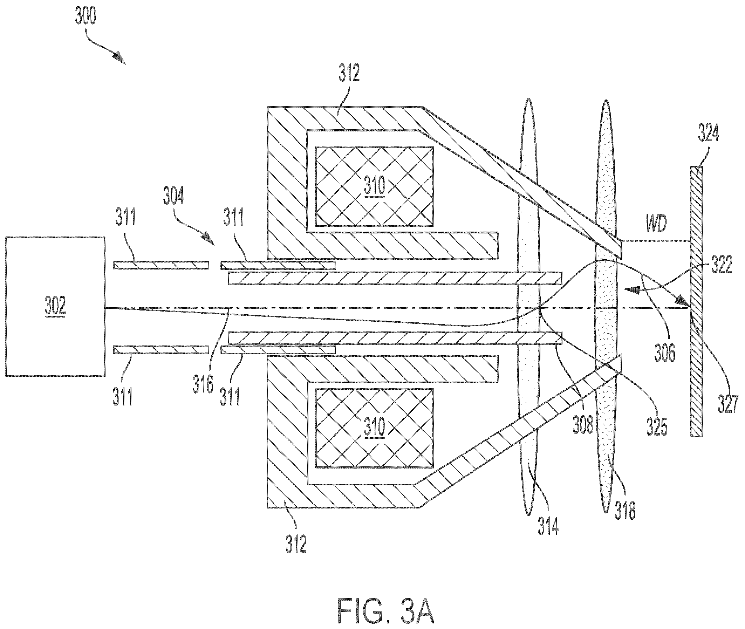

FIG. 3A depicts a simplified cross-sectional view of an example charged particle system having navigation mode. Various components of the charged particle system 200 may be relevant to the charged particle system 300 and similar components are similarly numbered and have similar form and function unless otherwise noted herein. Charged particle system 300 includes a source of charged particles 302, as described in detail above. A charged particle beam column 304 may be configured to focus the charged particles into a charged particle beam 306 having a landing energy. The charged particle beam column 304 may include a booster tube 308, a set of scanning deflectors 311, and a set of magnetic materials 312. The set of magnetic materials 312 may at least partially surround the booster tube 308 and the set of scanning deflectors 311, as shown in FIG. 3A.

According to various embodiments, a magnetic lens 314 is formed in the charged particle beam column 304 along an axis 316. The magnetic lens 314 may be based on a magnetic lens excitation in the set of coils 310. For example, a current may be applied to the set of coils 310 that forms the magnetic lens 314, as would be appreciated by one having ordinary skill in the art. Furthermore, the charged particle system 300 may include an electrostatic lens 318 formed along the axis 316 in the charged particle beam column 304. The electrostatic lens 318 may be formed based at least in part on a voltage applied to the booster tube 308. According to embodiments of the present disclosure, the magnetic lens 314 focuses the charged particle beam 306 at a first crossover 325 on the axis 316. The first crossover 325 is between the magnetic lens 314 and the electrostatic lens 318. In various embodiments, the first crossover 325 is based on the magnetic lens excitation forming the magnetic lens 314. According to at least some embodiments, the first crossover 325 is proximate to an end of the booster tube 308, wherein the end is between the magnetic lens 314 and the electrostatic lens 318 as shown in FIG. 3A. Furthermore, embodiments of the present disclosure provide that the electrostatic lens 318 focuses the charged particle beam 306 at a second crossover 327 on the axis 316.

The magnetic lens excitation may affect the position of the first crossover 325. In some embodiments, the magnetic lens excitation is non-linear. However, in at least some other embodiments, the magnetic lens excitation may be proportionate. In various embodiments, the magnetic lens excitation, in terms of magnetomotive force provided by the magnetic lens, is between 200 Ampere-turns and 1000 Ampere-turns, inclusive.

FIG. 3A illustrates, as a dashed line, the path of an axial ray of a charged particle beam 306 during its passage through the final lens (e.g., electrostatic lens 318) where the width of the beam 306 is magnified at the final lens by application of the methods of the present disclosure. According to this exemplary embodiment, there is no scanning and the charged particle beam 306 has two crossovers (e.g., the first crossover 325 and the second crossover 327) at the sample 324. In at least some embodiments, the cross section of the charged particle beam 306 is relatively small (e.g., between about 40 micrometers and 100 micrometers, inclusive).

A working distance (WD) refers to the distance between an outlet 322 of the charged particle beam column 304 and a surface of a sample 324 or the like. According to various embodiments of the present disclosure, the first crossover 325 and the second crossover 327 increase the maximum working distance for low landing energies on a SEM with a booster tube 308 and enable navigation in a large field of view. For example, the working distance of the charged particle beam column 304 is greater than or equal to 1 mm. In at least some embodiments, the working distance of the charged particle beam column 304 is greater than the maximum working distance of the conventional system without the embodiments described herein. Again, if the maximum working distance is too short at low landing energy, the field of view cannot be extended into dimensions that would enable navigation. In the present disclosure, focusing of the sample 324 to a resulting image is steered by influencing the longitudinal position of the extra crossover (e.g., second crossover 327). The lens equation supports the finding that the image side of the SEM may be positioned a relatively far distance from the charged particle beam column 304.

Various embodiments of the present disclosure create a second crossover (e.g., second crossover 327) in front of the electrostatic lens 318 (i.e., within a spatial region that is opposite to a side of the electrostatic lens that faces the booster tube 308) such that the electrostatic lens 318 uses its refraction power to transfer the second crossover to the beam spot at the sample (e.g., along sample 324). For example, embodiments of the present disclosure use the strong refraction of the electrostatic lens 318 to create an additional transfer stage with the extra crossover (e.g., second crossover 327). Accordingly, the embodiments of the present disclosure advantageously overcome the low landing energy (e.g., greater than or equal to 1 eV and less than or equal to 500 eV) produced as a result of using the booster tube. The electrostatic lens 318 may have a constant refraction power (e.g., as a result of a constant voltage applied thereto).

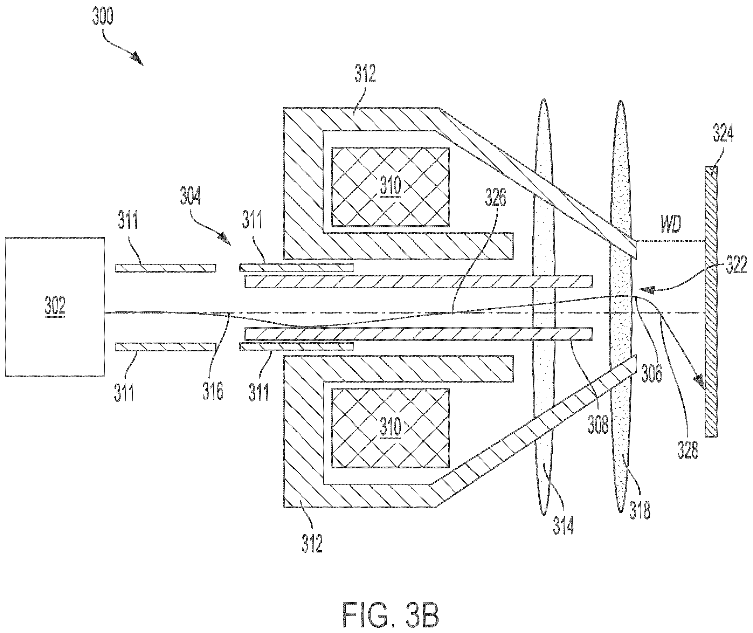

FIG. 3B depicts the simplified cross-sectional view of an example charged particle system having navigation mode of FIG. 3A scanning a relatively large field of view. The actual correction in focus is produced by the magnetic lens 314. FIG. 3B shows the charged particle beam 306 now approximated just as a single line (e.g., along the center of the beam) that is deflected due to presence of scanning deflectors 311. The two crossovers with the optical axis (e.g., the first pivot point 326 and the second pivot point 328) of the charged particle beam 306 due to the scanning enables the large field of view available in the navigation mode. Accordingly, electrons with relatively small landing energies are focused at least twice (e.g., with the magnetic lens 314 and with the electrostatic lens 318). As such, an advantage of at least some embodiments of the present disclosure is the addition of a navigation to an SEM system with a booster tube, thereby enabling imaging of a relatively far field of view on the order of smaller tens of millimeters.

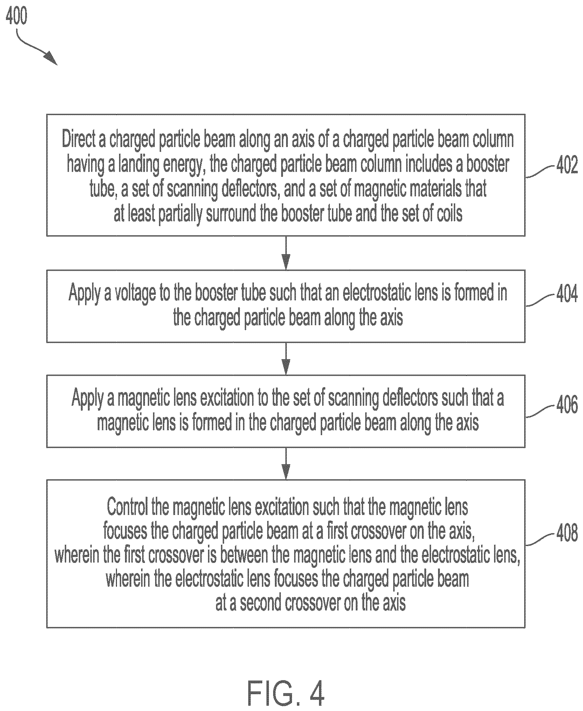

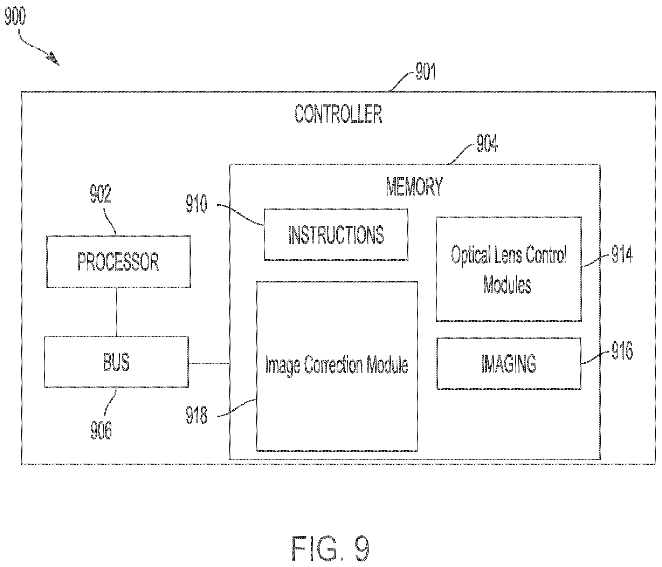

FIG. 4 is a flowchart of a method for imaging a target. Imaging a target according to method 400 may include any of the embodiments described herein. For example, imaging the target may be performed by the charged particle system 300 described with respect to FIGS. 3A and 3B. Various steps of method 400 may be implemented by one or more of the controllers described herein. For example, one or more steps of method 400 may be implemented by controller 130 described in detail above with respect to FIG. 1. In another example, one or more steps of method 400 may be implemented by the controller 901, to be described in further detail below with respect to FIG. 9.

Method 400 includes step 402. Step 402 includes directing a charged particle beam along an axis of a charged particle beam column having a landing energy. The charged particle beam column includes a booster tube, a set of scanning deflectors, and a set of magnetic materials that at least partially surround the booster tube and the set of scanning deflectors, as described in detail above.

Method 400 further includes step 404 including applying a voltage to the booster tube such that an electrostatic lens is formed in the charged particle beam along the axis. The potential applied to the booster tube may vary between 6000 V to 10000 V, inclusive. According to various embodiments, the voltage applied to the booster tube is constant during imaging of a sample and the imaging is based on the landing energy, as would be appreciated by one having ordinary skill in the art upon reading the present disclosure. In various embodiments, a voltage may be further applied to the magnetic material to create a voltage differential between the magnetic material and the booster tube. In at least some embodiments, the voltage applied to the magnetic material is set to zero, for example, during a standard situation with the magnetic circuit yoke set to the ground potential, i.e. zero Volts. In other embodiments, a positive or negative potential may be applied to a part of the magnetic circuit yoke in a range between -3000 to +3000 Volts, inclusive.

Method 400 further includes step 406 including apply an electrical excitation to the magnetic lens coils such that a magnetic lens is formed in the charged particle beam along the axis. According to various embodiments, applying an electrical excitation includes applying a current to the magnetic lens coils. The magnetic lens excitation, in terms of magnetomotive force provided by the magnetic lens, may be between 200 Ampere-turns to 1000 Ampere-turns, inclusive.

Method 400 includes step 408. Step 408 includes controlling the electrical excitation such that the magnetic lens focuses the charged particle beam at a first crossover on the axis. Step 408 may further include controlling the magnetic lens excitation such that the working distance of the charged particle beam column is equal to or greater than 1 mm. The first crossover may be between the magnetic lens and the electrostatic lens. The electrostatic lens may further focus the charged particle beam at a second crossover on the axis. The magnetic lens excitation (e.g., the current) applied to the magnetic lens coils may be adjusted as desired to modify the working distance and/or the field of view. Accordingly, embodiments of the method 400 and described herein provide a navigation mode for an SEM system having a booster tube.

According to some embodiments, the system may be preset with a range of usable electrical excitation (e.g., voltage and/or current, etc.). Through previous calibration/testing, the system may map values of the range to crossover distances and/or working distances. The mapping may be stored in a table, database or the like in the memory of the controller or in any other manner known in the art. Accordingly, step 408 may include receiving input indicating a crossover distance or working distance and the controller may use the stored look up the table and determine the value of the current and/or voltage to be applied and controls the magnetic lens excitation accordingly.

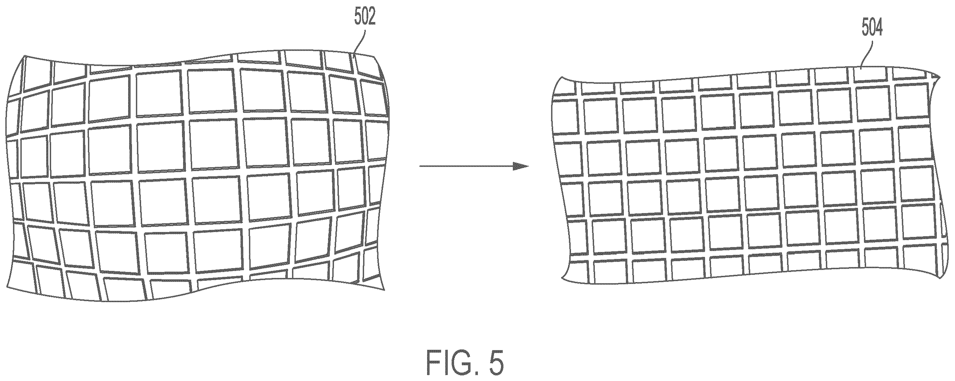

FIG. 5 illustrates image distortion and correction. There may be a certain measure of distortion of an image captured according to various embodiments described above. For example, image distortion may be caused by spherical aberration of the electrostatic lens. Some distortion may occur during imaging using the navigation mode described herein. The compound magnetic lens and electrostatic lens refract electron beams. The greater distance of rays from the optical axis in the electrostatic lens may cause some image distortion. Various embodiments describe a model of distortion and the implementation of an undistortion procedure using digital post-processing.

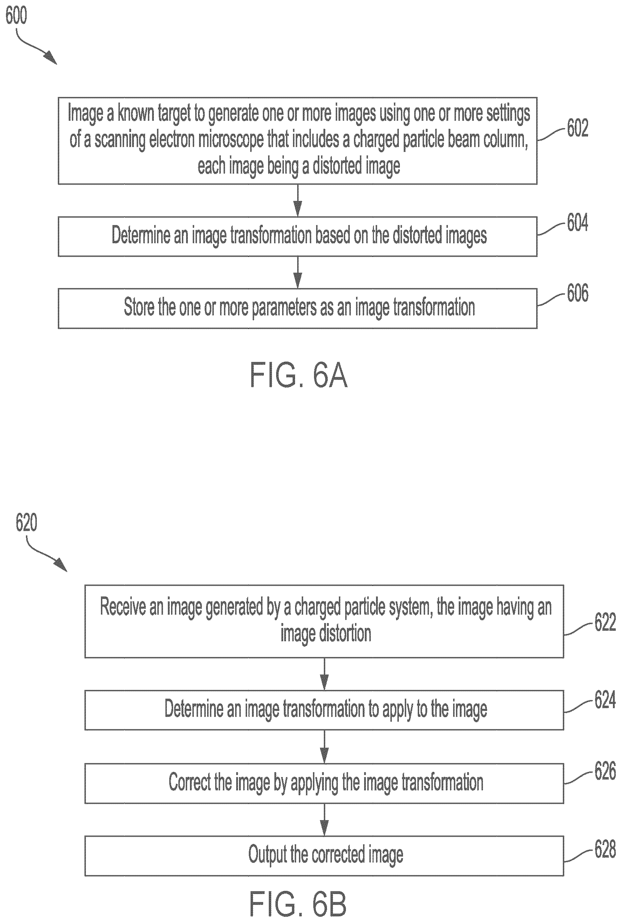

As shown in FIG. 5, image 502 is an exemplary image having image distortion and generated by imaging according to method 400 described in detail above. For example, image 502 includes expanded portions in the middle of the image and compressed portions toward the edges of the image. Image 502 may be distorted by a pin cushion distortion, barrel distortion, or the like, in the imaging. According to various methods described herein, post-processing may transform image 502 to image 504, where the image 504 is the corrected image and includes less distortions and can possibly be distortion free. Embodiments described herein, especially with respect to FIGS. 6A and 6B, illustrate methods of post-processing images generated according to method 400 of FIG. 4.

FIGS. 6A and 6B include flowcharts of a method for correcting image distortion. The images to be corrected may be imaged according to method 400 including any of the embodiments described herein. For example, imaging the target may be performed by the charged particle system 300 described with respect to FIGS. 3A and 3B. Various steps of method 600 and method 620 may be implemented by one or more of the controllers described herein. For example, one or more steps may be implemented by controller 130 described in detail above with respect to FIG. 1. In another example, one or more steps may be implemented by the controller 901, to be described in further detail below with respect to FIG. 9.

FIG. 6A illustrates method 600. Method 600 include step 602 including imaging a known target using one or more settings of a scanning electron microscope that includes the charged particle beam column described herein. In various embodiments, the image includes an image distortion. The known target may include a checkerboard, stripes, a known pattern, a shape, a series of shapes, etc. According to some embodiments, step 602 includes generating a plurality of images of the known target where each image corresponds to a different one of a plurality of settings of the scanning electron microscope. According to some embodiments, step 602 further includes generating a plurality of images of multiple known targets. In some embodiments, an image of the known target can be generated and correspond to one or more of: a particular value of the first crossover, a particular value of the second crossover, a position of the known target, a beam characteristic, etc. These generated images may be referred to herein as distorted images.

Step 604 may further include determining an image transformation based on the distorted images. The image transformation may be further based on true images of the known target(s), according to some embodiments. These true images may be known images that are distortion free (or significantly distortion free). According to some embodiments, the transformation may be output by a virtual model, where the virtual model is trained using the distorted images and the true images. The virtual model may receive a distorted image and output a corrected image. Any difference between the corresponding true image and the output image may be used to update the virtual model. This process may be repeated for a plurality of distorted images for iteratively updating the virtual model. In various embodiments, the virtual model may include a non-machine learning model. For instance, the virtual model may be a data fitting model that iteratively estimates the parameters of the transformation such that the transformed image removes the image distortion. Different types of data fitting models are possible, such as those based on implementations of the Levenberg-Marquardt nonlinear least squares algorithm, a chi-square test algorithm, a curve fitting algorithm, a weighted least square fittings algorithm, a polynomial regression algorithm, a Gauss-Newton algorithm, shift-cutting algorithm, a gradient algorithm, a Nelder-Mead (simplex) search algorithm, or other types of fitting algorithms. Additionally, or alternatively, the virtual model may include a machine learning model, such as a regression model or a convolutional neural network can be trained using multiple known virtual models and corresponding display assemblies to output transformation parameters. The training can include inputting the distorted images to the machine learning model and using the corresponding true images as ground truth. From a distorted image, the machine learning model can output a corrected image. The corrected image can be compared to a corresponding true image. A difference between the corrected image and the true image can be used in a feedback loop to update the parameters of the machine learning model. In embodiments where the virtual model is a machine learning model, the virtual model may not output the image transformation. Instead, parameters of the virtual model may correspond to a learned knowledge of what the image transformation can be. It is possible that the machine learning model is trained across all microscope settings.

According to some embodiments where the virtual model is a non-machine learning model, an image transformation can be output by the virtual model and can correspond to a particular microscope setting. In such embodiments, the image transformations can be stored, at step 606, in association with the microscope settings (e.g., in a table or a database). For a particular setting, the corresponding image transformation may be retrieved from storage. According to some embodiments, where the virtual model is a machine learning model, the virtual model itself can be stored at step 606. One or more of the steps of method 600 may be performed offline or on a separate system (e.g., a system other than the charged particle system 300 of FIGS. 3A and 3B) according to various embodiments described herein. Thereafter, an image having an image distortion may be corrected using a pre-stored image transformation or the machine learning model as further described in method 620.

Method 620 includes step 622. Step 622 includes receiving an image generated by a charged particle system, such as charged particle system 300 of FIG. 3A and 3B. The image may include an image distortion. Step 624 may include determining an image transformation to apply to the image. The image transformation may be one of the image transformations generated and stored as part of method 600 described above and derived from different relevant settings of a microscope (e.g., such as by imaging a known target or from physics simulations). The image transformation can be looked up based on the microscope setting. Alternatively, the machine learning model can be called (e.g., over an application programming interface), where the call can include the image and, optionally, the microscope setting. Step 626 further includes correcting the image by applying the image transformation to the image. The image transformation may be applied as a function on its own or inherently applied by the machine learning model.

Step 628 may further include outputting the corrected image. According to some embodiments, the image distortion may be corrected based on the application of the image transformation to the image.

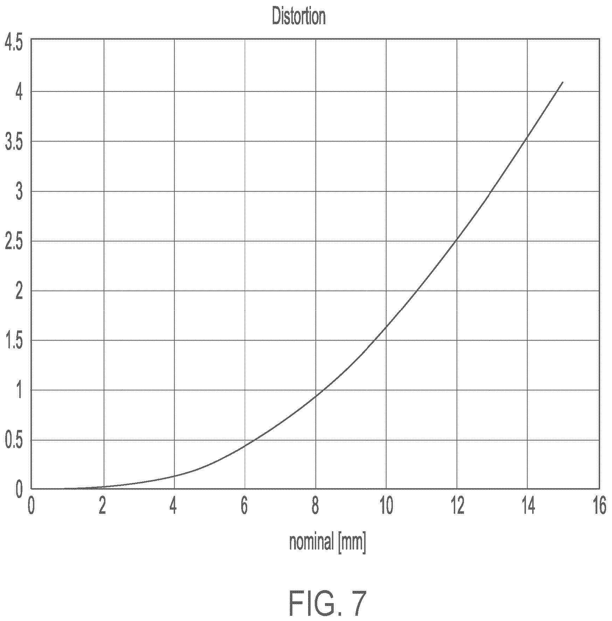

FIG. 7 is a graph representing image distortion. In particular, FIG. 7 is a graph of image distortion to be compensated. Various images may be taken for various settings, as described above. For example, for each setting of the system, a characteristic of the beam and/or the distance of a sample to the output of the booster tube is varied to derive a distortion curve such as the one shown in FIG. 7. From the distortion curve, coefficients for an image transformation for that specific setting may be derived, as would be appreciated by one having ordinary skill in the art upon reading the present disclosure. The distortion may be understood as a deviation of the intersection position of the electron beam and the sample in reality and nominally.

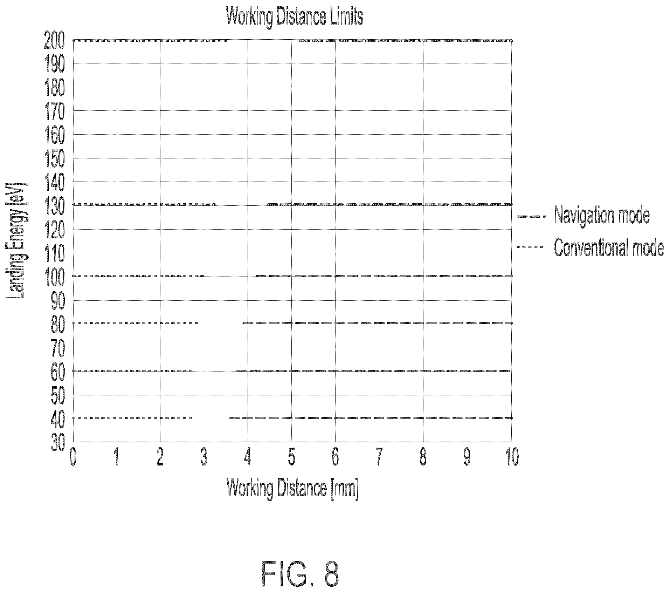

FIG. 8 is a table representing exemplary working distances. FIG. 8 includes working distance limits for navigation mode as described herein and conventional systems. Navigation mode as described herein may be available for landing energies up to 500 eV and the maximum working distance will have no restrictions.

FIG. 9 is a block diagram of a controller for a charged particle microscope system. Examples of the electron microscope system can include the charged particle system 300 described with respect to FIGS. 3A and 3B. As shown, the controller 901 includes a processor 902 communicatively coupled to memory 904. The processor 902 can include one processing device or multiple processing devices. Non-limiting examples of the processor 902 include a Field-Programmable Gate Array (FPGA), an application specific integrated circuit (ASIC), a microprocessor, or any combination of these. The processor 902 can execute instructions 910 stored in the memory 904 to perform operations, such as the operations of process 900 from FIG. 9. In some examples, the instructions 910 can include processor-specific instructions generated by a compiler or an interpreter from code written in any suitable computer-programming language, such as C, C++, C#, Python, or Java.

The memory 904 can include one memory device or multiple memory devices. The memory 904 can be non-volatile and may include any type of memory device that retains stored information when powered off. Non-limiting examples of the memory 904 include electrically erasable and programmable read-only memory (EEPROM), flash memory, or any other type of non-volatile memory. At least some of the memory 904 can include a non-transitory computer-readable medium from which the processor 902 can read instructions 910 via bus 906. The bus 906 may be a communication and/or power bus that enables processor 902 to communicate with memory 904. The non-transitory computer-readable medium can include electronic, optical, magnetic, or other storage devices capable of providing the processor 902 with the instructions 910 or other program code. Non-limiting examples of the non-transitory computer-readable medium include magnetic disk(s), memory chip(s), RAM, an ASIC, or any other medium from which a computer processor can read instructions 910.

The memory 904 can further include optical lens control modules 914 for controlling the voltage and/or current according to various embodiments of the present disclosure including at least the charged particle system 300 of FIGS. 3A and 3B and method 400 of FIG. 4. The memory 904 can further include an imaging module 916 for generating, storing, processing, etc., images produced by the charged particle system 300 of FIGS. 3A and 3B and the method 400 of FIG. 4. The memory 904 can further include an image correction module 918 for implementing various embodiments of the method 600 described in detail above for post-processing images generated at least by the charged particle system 300 of FIGS. 3A and 3B and method 400 of FIG. 4.

While exemplary embodiments have been illustrated and described, it will be appreciated that various changes can be made therein without departing from the spirit and scope of the disclosure.

The systems, apparatus, and methods described herein should not be construed as limiting in any way. Instead, the present disclosure is directed toward all novel and non-obvious features and aspects of the various disclosed embodiments, alone and in various combinations and sub-combinations with one another. The disclosed systems, methods, and apparatus are not limited to any specific aspect or feature or combinations thereof, nor do the disclosed systems, methods, and apparatus require that any one or more specific advantages be present, or problems be solved. Any theories of operation are to facilitate explanation, but the disclosed systems, methods, and apparatus are not limited to such theories of operation.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatus can be used in conjunction with other systems, methods, and apparatus. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one of ordinary skill in the art.

In some examples, values, procedures, or apparatuses are referred to as "lowest", "best", "minimum," or the like. It will be appreciated that such descriptions are intended to indicate that a selection among many used functional alternatives can be made, and such selections need not be better, smaller, or otherwise preferable to other selections.

## Claims

1. A charged particle beam system comprising:
a source of charged particles; and
a charged particle beam column configured to focus the charged particles into a charged particle beam having a landing energy, wherein:
the charged particle beam column includes a booster tube, a set of scanning deflectors, and a set of magnetic materials that at least partially surround the booster tube and the set of scanning deflectors,
a magnetic lens is formed in the charged particle beam column along an axis based on a magnetic lens excitation in the coils, the magnetic lens configured to focus the charged particle beam at a first crossover on the axis,
an electrostatic lens is formed in the charged particle beam column along the axis based on a voltage applied to the booster tube, the electrostatic lens configured to focus the charged particle beam at a second crossover on the axis; and
the first crossover is between the magnetic lens and the electrostatic lens and is based on the magnetic lens excitation.

2. The system of claim 1, wherein the landing energy is greater than or equal to 1 eV and less than or equal to 500 eV.

3. The system of claim 1, wherein a working distance of the charged particle beam column is greater than or equal to 1 mm.

4. The system of claim 3, wherein the working distance is based on the magnetic lens excitation.

5. The system of claim 3, wherein the voltage is constant during imaging of a sample at the working distance, wherein the imaging is based on the landing energy.

6. The system of claim 1, wherein the first crossover is proximate to an end of the booster tube, wherein the end is between the magnetic lens and the electrostatic lens.

7. A method for imaging a target, the method comprising:
directing a charged particle beam along an axis of a charged particle beam column having a landing energy, the charged particle beam column includes a booster tube, a set of scanning deflectors, and a set of magnetic materials that at least partially surround the booster tube and the set of scanning deflectors;
applying a voltage to the booster tube such that an electrostatic lens is formed in the charged particle beam along the axis;
applying a magnetic lens excitation such that a magnetic lens is formed in the charged particle beam along the axis; and
controlling the magnetic lens excitation such that the magnetic lens focuses the charged particle beam at a first crossover on the axis, wherein the first crossover is between the magnetic lens and the electrostatic lens, wherein the electrostatic lens focuses the charged particle beam at a second crossover on the axis.

8. The method of claim 7, further comprising:
receiving an image including an image distortion; and
correcting for the image distortion by image post-processing or by altering the excitation of the set of scanning deflectors, wherein correcting for the image distortion comprises using a virtual model to apply a transformation to the image.

9. The method of claim 7, further comprising:
imaging a known target using at least a first setting of a scanning electron microscope that includes the charged particle beam column;
determining an image transformation based on the imaging of the known target;
generating an image of the known target at a working distance based on the charged particle beam; and
updating the image based on the image transformation.

10. The method of claim 8, further comprising:
controlling the magnetic lens excitation such that the working distance of the charged particle beam column is equal to or greater than1 mm.

11. The method of claim 9, further comprising:
generating a plurality of images of the known target, each image corresponding to a different one of a plurality of settings of the scanning electron microscope, wherein the image transformation is based on the plurality of images.

12. The method of claim 9, wherein imaging the known target comprises:
generating an image of the known target by at least varying one or more of the first crossover, the second crossover, a position of the known target, or a beam characteristic, wherein the image transformation is based on the image.

13. The method of claim 7, wherein the landing energy is greater than or equal to 1 eV and less than or equal to 500 eV.

14. The method of claim 7, further comprising:
controlling the magnetic lens excitation such that the first crossover is proximate to an end of the booster tube.

15. A computer program comprising program code which, when executed by a set of processors, causes the method steps of any one of claims 7-14 to be carried out.
